# EUROPEAN PATENT APPLICATION

(11) **EP 2 579 681 A1**
(43) Date of publication of application: **10.04.2013**
(21) Application number: 10852148.5
(22) Date of filing: 26.05.2010
(51) Int. Cl.: H05B 33/00, H01L 51/50

(54) **LIGHT-EMITTING ELEMENT, IMAGE DISPLAY DEVICE, AND LIGHTING DEVICE**

(71) Applicant: Showa Denko K.K., Tokyo 105-8518 (JP)
(72) Inventor: KONDO, Kunio, Chiba-shi Chiba 267-0056 (JP); SAKO, Kanjiro, Chiba-shi Chiba 267-0056 (JP)
(74) Representative: Strehl Schübel-Hopf & Partner
(86) International application number: PCT/JP2010/058933
(87) International publication number: WO 2011/148478

(57) **Abstract**

Disclosed is a light-emitting element 10 including: an anode layer 12, a dielectric layer 13 and a cathode layer 14 successively laminated on a surface of a substrate 11; plural penetrating portions 16 that penetrate at least the dielectric layer 13 and extend from the anode layer 12 to the cathode layer 14; and a light-emitting portion 17 that covers at least between the both electrode layers on an inner surface of each of the plural penetrating portions 16, wherein a perimeter of a shape of each of the plural penetrating portions 16 on a surface of the anode layer 12 is longer than a perimeter of a minimum circle enclosing the shape, and a maximum width of the shape is in a range of 0.01 µm to 5 µm, thereby providing a light-emitting element having high luminance and light-emitting efficiency.

## Description

### Technical Field

The present invention relates to a light-emitting element used for, for example, an image display device or a lighting device.

### Background Art

In recent years, devices utilizing the electroluminescence phenomenon have increased in importance. As such a device, a light-emitting element such as an electroluminescent element, in which light-emitting materials are formed to be a light-emitting layer, and a pair of electrodes including an anode and a cathode is attached to the light-emitting layer, and light is emitted by applying a voltage thereto, becomes a focus of attention. In this kind of electroluminescent element, a hole and an electron are injected from the anode and the cathode, respectively, by applying a voltage between the anode and the cathode, and an energy generated by coupling the injected electron and hole in the light-emitting layer is used to perform light emission. In other words, the electroluminescent element is a device utilizing a phenomenon in which the light-emitting material in the light-emitting layer is excited by the energy produced by the coupling, and light is emitted when an excited state returns to a ground state again.

In the case where the light-emitting element such as the electroluminescent element is used as an image display device, since the light-emitting material is capable of self-emitting, the device has characteristics that a speed of response as the image display device is fast and an angle of visibility is wide. Further, due to its structural feature of the electroluminescent element, there is an advantage that the thickness of the image display device may be reduced with ease. Moreover, in the case of an organic electroluminescent element using, for example, an organic substance as the light-emitting material, characteristics are obtained such that light with high color purity is readily obtained depending upon selection of the organic substance, and thereby a wide color gamut is available.
Further, the light-emitting element such as the electroluminescent element is capable of emitting white light, and is an area light source, a use of the electroluminescent element to be incorporated into a lighting device is suggested.

As a configuration of such a light-emitting element, Patent Document 1, for example, suggests a cavity-emission electroluminescent device including a dielectric layer interposed between a hole-injecting and electron-injecting electrode layers, in which an extension portion (cavity) extends through at least the dielectric layer and one of the electrode layers and an interior cavity surface has a hole-injection electrode region, an electron-injection electrode region and a dielectric region, and an electroluminescent coating material is applied to the interior cavity surface.

### Citation List

### Patent Literature

Patent Document 1: Japanese Patent Application Unexamined Publication (Translation of PCT Application) No. 2003-522371

### Disclosure of Invention

### Technical Problem

In Patent Document 1, a circular cylinder or a cube is exemplified as a shape of the cavity; however, the cross-sectional shape of the light-emitting element at a substrate surface thereof is a circle or a polygon whose total length of all sides is shorter than a perimeter of a minimum enclosing circle thereof. In the cavity-emission electroluminescent device in which light is emitted at a portion where the cavity is formed, it cannot be said that the above-described shape of cavity effectively uses the area of the light-emitting surface. Besides, since concentration of electrical charge is apt to occur inside the cavity, there is a limit to the extent to which the light-emitting strength is increased by feeding a large current. Further, light generated inside the electroluminescent coating material cannot be taken out to the outside effectively, thus causing a problem of low light-emitting efficiency.
An object of the present invention is to provide a light-emitting element in which electrical charge concentration hardly occurs in a light-emitting portion, the area of the light-emitting surface is effectively used, and luminance and light-emitting efficiency are high owing to a shape of a cavity having high efficiency of extraction of light to the outside. Another object of the present invention is to provide an image display device or a lighting device having high light-emitting efficiency by use of the above-described light-emitting element.

### Solution to Problem

According to a first aspect of the present invention, for addressing the above-described problems, there is provided a light-emitting element including: a substrate; a first electrode layer, a dielectric layer and a second electrode layer successively laminated on a surface of the substrate; plural penetrating portions that penetrate at least the dielectric layer and extend from the first electrode layer to the second electrode layer; and a light-emitting portion that covers at least a portion between the first electrode layer and the second electrode layer on an inner surface of each of the plural penetrating portions, wherein a perimeter of a shape of each of the plural penetrating portions on a surface of the first electrode layer is longer than a perimeter of a minimum circle enclosing the shape, and a maximum width of the shape is in a range of 0.01 µm to 5µm.
According to a second aspect of the present invention, in the first aspect of the light-emitting element, the plural penetrating portions also penetrate the first electrode layer.
According to a third aspect of the present invention, in any one of the first and the second aspects of the light-emitting element, the plural penetrating portions also penetrate the second electrode layer.
According to a fourth aspect of the present invention, in any one of the first to the third aspects of the light-emitting element, the perimeter of the shape on the surface of the first electrode layer is in a range of 0.5 µm to 25 µm.
According to a fifth aspect of the present invention, in any one of the first to the fourth aspects of the light-emitting element, the perimeter of the shape on the surface of the first electrode layer is 1.15 to 2 times the perimeter of the minimum circle enclosing the shape.
According to a sixth aspect of the present invention, in any one of the first to the fifth aspects of the light-emitting element, the number of the penetrating portions formed on the surface of the substrate per 1 mm² is in a range of 10³ to 10⁸.
According to a seventh aspect of the present invention, in any one of the first to the sixth aspects of the light-emitting element, a total of the perimeters of the penetrating portions on the surface of the substrate per unit area is not less than 1 µm/µm².
According to an eighth aspect of the present invention, in any one of the first to the seventh aspects of the light-emitting element, the shape on the surface of the first electrode layer is a concave polygon.
According to a ninth aspect of the present invention, in any one of the first to the seventh aspects of the light-emitting element, the shape on the surface of the first electrode layer is a concave polygon whose apex portions are chamfered.
According to a tenth aspect of the present invention, in any one of the eighth and the ninth aspects of the light-emitting element, the concave polygon includes 8 or more apexes.
According to an eleventh aspect of the present invention, in any one of the eighth to the tenth aspects of the light-emitting element, sides of the concave polygon have the same length.
According to a twelfth aspect of the present invention, in any one of the first to the eleventh aspects of the light-emitting element, the shape on the surface of the first electrode layer has a fractal structure.
According to a thirteenth aspect of the present invention, in any one of the first to the twelfth aspects of the light-emitting element, the light-emitting portion includes a light-emitting layer containing a light-emitting body composed of at least an organic compound.
According to a fourteenth aspect of the present invention, in the thirteenth aspect of the light-emitting element, the organic compound is an organometallic complex.
According to a fifteenth aspect of the present invention, there is provided an image display device including the light-emitting element according to any one of the first to the fourteenth aspects of the present invention.
According to a sixteenth aspect of the present invention, there is provided an lighting device including the light-emitting element according to any one of the first to the fourteenth aspects of the present invention.

### Advantageous Effects of Invention

According to the present invention, it is possible to provide a light-emitting element having high luminance and light-emitting efficiency, in which electrical charge concentration hardly occurs in a light-emitting portion and the area of the light-emitting surface is effectively used, and to provide an image display device and a lighting device by use of the light-emitting element.

### Brief Description of Drawings

FIG. 1 is a partial cross-sectional view illustrating an example of a light-emitting element to which the exemplary embodiment is applied;
FIG. 2 illustrates shapes of penetrating portions of the light-emitting element to which the exemplary embodiment is applied, and arrangement thereof;
FIGS. 3A and 3B illustrate the shape of the penetrating portion in the light-emitting element according to the exemplary embodiment;
FIGS. 4A to 4D illustrate other shapes of the penetrating portion in the light-emitting element according to the exemplary embodiment, and method of forming thereof;
FIGS. 5A and 5B illustrate still other shapes of the penetrating portion in the light-emitting element according to the exemplary embodiment;
FIGS. 6A to 6C illustrate a case of two chamfering methods for the concave decagon;
FIGS. 7A to 7D illustrate other modes of the shape of the light-emitting portion;
FIGS. 8A to 8F illustrate various modes of the penetrating portion in the light-emitting element according to the present invention;
FIGS. 9A to 9F illustrate a manufacturing method of the light-emitting element to which the exemplary embodiment is applied;
FIG. 10 illustrates an example of an image display device equipped with the light-emitting element according to the exemplary embodiment; and
FIG. 11 illustrates an example of a lighting device equipped with the light-emitting element according to the exemplary embodiment.

### Description of Embodiments

An exemplary embodiment of the present invention will be described in detail below.

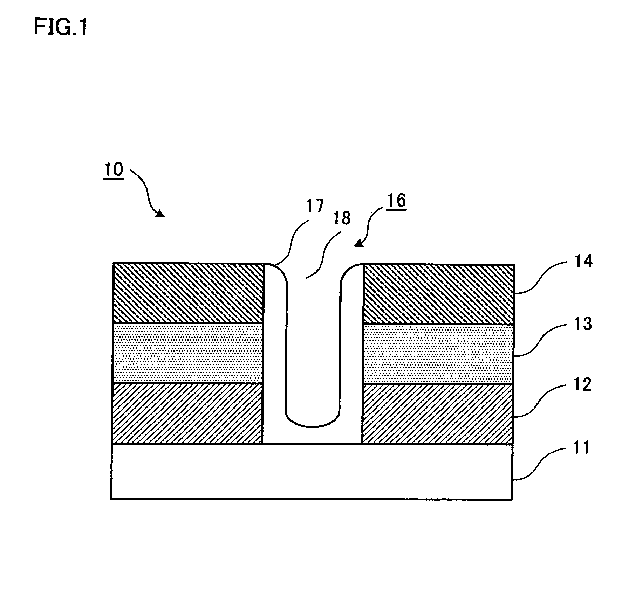

FIG. 1 is a partial cross-sectional view illustrating an example of a light-emitting element to which the exemplary embodiment is applied.
A light-emitting element 10 shown in FIG. 1 employs a configuration in which an anode layer 12 as a first electrode layer for hole injection, a dielectric layer 13 having insulating properties, and a cathode layer 14 as a second electrode layer for electron injection are laminated in this order on a substrate 11. The light-emitting element 10 further includes a penetrating portion 16 formed to penetrate the anode layer 12, the dielectric layer 13 and the cathode layer 14, and a light-emitting portion 17 that is formed to cover an inner surface of the penetrating portion 16 and emits light upon application of a voltage. The light-emitting portion 17 is formed on the inner surface of the penetrating portion 16 like a layer, not to fill in the penetrating portion 16 entirely, thus forming a cavity 18.

The substrate 11 is a base material that serves as a support body to form the anode layer 12, the dielectric layer 13, the cathode layer 14 and the light-emitting portion 17. As the substrate 11, a material that satisfies mechanical strength required for the light-emitting element 10 is used.

The material for the substrate 11, in the case where the light is to be taken out from the substrate 11 side of the light-emitting element 10, is required to be transparent to the emitted light. In the case of visible light, specific examples include glasses such as soda glass and alkali-free glass; and transparent resins such as acrylic resins, methacrylic resins, polycarbonate resins, polyester resins and nylon resins.
In the case where it is unnecessary to take out the light from the substrate 11 side of the light-emitting element 10, the material of the substrate 11 may be opaque to the emitted light. The specific examples of the material of the substrate 11 includes, in addition to the above-described materials, a simple substance of metals such as copper (Cu), silver (Ag), gold (Au), platinum (Pt), tungsten (W), titanium (Ti), tantalum (Ta) and niobium (Nb), alloys thereof, or stainless steel.
The thickness of the substrates may satisfy the mechanical strength required, which is usually in the range of 0.1 mm to 10 mm, and preferably 0.25 mm to 2 mm.

Upon application of a voltage between the anode layer 12 and the cathode layer 14, the anode layer 12 injects holes into the light-emitting portion 17. The material used for the anode layer 12 is not limited as long as the material has electrical conductivity; however, the material may have a sheet resistance of not more than 1000Ω, and preferably not more than 100Ω at temperatures of -5°C to 80°C, and in addition, preferably do not change greatly the electric resistance in alkaline aqueous solutions.

As the material satisfying the above requirements, examples include metal oxides, metals and alloys. As the metal oxides, indium tin oxide (ITO) and indium zinc oxide (IZO) are provided. Further, as metals, provided are: stainless steel; copper (Cu); silver (Ag); gold (Au); platinum (Pt); tungsten (W); titanium (Ti); tantalum (Ta) and niobium (Nb); and alloys of these metals. As a transparent material used to form a transparent electrode, examples include: indium oxide; zinc oxide; tin oxide, electrical conductive glasses made of complexes thereof such as indium tin oxide (ITO) and indium zinc oxide (IZO); gold; platinum; silver and copper. Among these, ITO, IZO and tin oxides may be preferably used. Moreover, a transparent electrical conductive film made of an organic substance such as polyaniline or derivative thereof and polythiophene or derivative thereof may be used. In terms of facilitating the injection of holes into the light-emitting portion 17, a layer having a thickness of 1 nm to 200 nm, which is made of: conductive polymer such as phthalocyanine derivative and polythiophene derivative; molybdenum oxide; amorphous carbon; fluorocarbon; polyamine compound, or a layer having an average thickness not more than 10 nm, which is made of metal oxide, metal fluoride or organic insulation material, may be formed on a surface of the anode layer 12 that is in contact with the light-emitting portion 17.

In the case where the light is to be taken out from the substrate 11 side of the light-emitting element 10, it is desirable that the anode layer 12 has a high light transmittance, and thereby the thickness of the anode layer 12 is preferably in the range of 2 nm to 300 nm. In the case where it is unnecessary to take out the light from the substrate 11 side of the light-emitting element 10, the anode layer 12 may be formed, for example, in the thickness of 2 nm to 2 mm.
It should be noted that the anode layer 12 may be formed of the same material used for the substrate 11. In this case, the anode layer 12 and the substrate 11 are formed in one unit.

The dielectric layer 13 is formed between the anode layer 12 and the cathode layer 14 to separate these layers with a predetermined spacing and provide insulation therebetween, and to apply a voltage to the light-emitting portion 17. Accordingly, the dielectric layer 13 is preferably made of a material having high resistance, more preferably a resistance of not less than 10⁸ Ω·cm, and still more preferably a resistance of not less than 10¹² Ω·cm. Specific examples of the material include: metal nitrides such as silicon nitride, boron nitride and aluminum nitride; and metal oxides such as silicon oxide and aluminum oxide; and in addition, polymer compound such as polyimide, polyvinylidene fluoride and parylene may be used.

The dielectric layer 13 may be configured with two layers or more as long as the electrical insulation property is preserved. Specifically, in addition to the layer made of an insulation body, another layer made of an insulation body, a layer made of a conductive body, a layer made by dispersing a conductive body in an insulation body, a layer made by dispersing an insulation body in another insulation body, a layer made of a semiconductor and the like may be laminated. Specific examples include: metal nitrides such as silicon nitride, boron nitride and aluminum nitride; and metal oxides such as silicon oxide, aluminum oxide, indium oxide, zinc oxide, tin oxide and composite thereof such as ITO (indium tin oxide) and IZO (indium zinc oxide); metals such as copper (Cu), silver (Ag), gold (Au), platinum (Pt), tungsten (W), titanium (Ti), tantalum (Ta) and niobium (Nb); organic conductive materials such as conductive polymers and organic EL materials; and materials in which graphite, alumina, boron nitride, carbon nanotube, diamond powder or silicone powder is dispersed in an insulating material such as resin.

The thickness of the dielectric layer 13 is preferably less than 1 µm for suppressing an entire thickness of the light-emitting element 10. Further, since the narrower the space between the anode layer 12 and the cathode layer 14, the lower the voltage required to emit light, it is preferable to make the dielectric layer 14 thin from this viewpoint. However, if the dielectric layer 14 is too thin, the dielectric strength becomes possibly insufficient against the voltage for driving the organic electroluminescent element 10. Here, the dielectric strength is preferably not more than 0.1 mA/cm² in current density passing between the anode layer 12 and the cathode layer 14 in the state where the light-emitting portion 17 is not formed, and more preferably not more than 0.01 mA/cm². Further, since dielectric strength preferably endures the driving voltage of the light-emitting element 10 exceeding 2V, the aforementioned current density may be satisfied in the case of, for example, the driving voltage of the light-emitting element 10 of 5V, when the voltage of about 7V is applied between the anode layer 12 and the cathode layer 14 in the state where the light-emitting portion 17 is not formed. The thickness of the dielectric layer 13 that satisfies these requirements may preferably be 10 nm to 500 nm, and more preferably 50 nm to 200 nm.

The cathode layer 14 injects the electron into the light-emitting portion 17 upon application of a voltage between the anode layer 12 and the cathode layer 14. The material used for the cathode layer 14 is not particularly limited as long as, similar to that of the anode layer 12, the material has electrical conductivity; however, the material that has a low work function and is chemically stable is preferred. In view of chemical stability, it is preferable to use materials having a work function of not more than -2.9 eV. The specific examples of the material include Al, MgAg alloy and alloys of Al and alkali metals such as AlLi and AlCa. The thickness of the cathode layer 14 is preferably in the range of 10 nm to 1 µm, and more preferably 50 nm to 500 nm.

To lower the barrier for the electron injection from the cathode layer 14 into the light-emitting portion 17 and thereby to increase the electron injection efficiency, a cathode buffer layer that is not shown in the figure may be provided adjacent to the cathode layer 14. The cathode buffer layer is required to have a lower work function than the cathode layer 14, and metallic materials are preferably used therefor. Examples of such materials include alkali metals (Na, K, Rb and Cs), alkaline earth metals (Sr, Ba, Ca and Mg), rare earth metals (Pr, Sm, Eu and Yb), one selected from fluoride, chloride and oxide of these metals and mixture of two or more selected therefrom. The thickness of the cathode buffer layer is preferably in the range of 0.05 nm to 50 nm, more preferably 0.1 nm to 20 nm, and still more preferably 0.5 nm to 10 nm.

The penetrating portion 16 has the light-emitting portion 17 inside thereof, penetrates at least the dielectric layer 13 and reaches the cathode layer 14 from the anode layer 12. In the exemplary embodiment, the penetrating portion 16 is formed to penetrate the anode layer 12 that serves as the first electrode layer, the dielectric layer 13 and the cathode layer 14 that serves as the second electrode layer. Forming the penetrating portion 16 in this manner enables the light emitted from the light-emitting portion 17 to propagate inside the penetrating portion 16, the anode layer 12, the dielectric layer 13 and the like to be taken out in both directions of the substrate 11 and the cathode layer 14. Here, since the penetrating portion 16 is formed to penetrate the anode layer 12, the dielectric layer 13 and the cathode layer 14, it is possible to take out the light even though the anode layer 12 that serves as the first electrode layer and the cathode layer 14 that serves as the second electrode layer are made of non-transparent material.

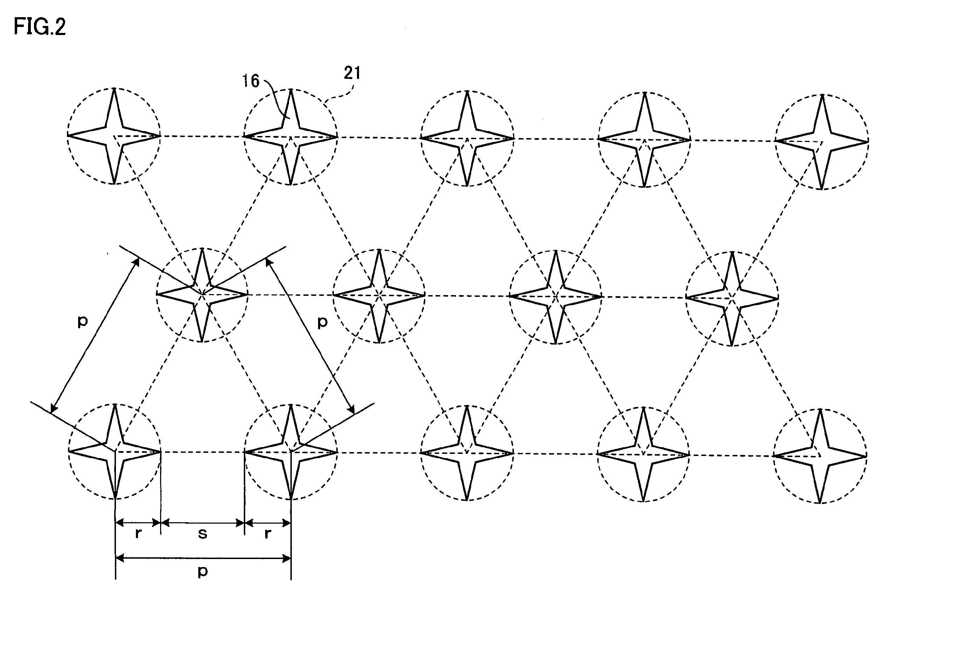

FIG. 2 illustrates shapes of the penetrating portions 16 of the light-emitting element 10 to which the exemplary embodiment is applied, and arrangement thereof. Here, FIG. 2 shows the light-emitting element 10 as viewed from a direction perpendicular to the surface of the anode layer 12 that serves as the first electrode layer.

In FIG. 2, the penetrating portion 16 has, though described in detail later, a shape of concave octagon. The penetrating portions 16 in adjacent rows are arranged in a staggered arrangement. Minimum circles 21 (minimum enclosing circles) that enclose the respective concave octagons are assumed and the minimum circles 21 are arranged so that three line segments, each of which connects centers of adjacent minimum circles 21, constitute an equilateral triangle. Here, on the assumption that the length of a side of the equilateral triangle is a pitch (p) and the distance between outer edge portions of adjacent minimum circles is a separation (s), the following relation is established among p, s and the radius of the minimum circle 21 (r): p = s+2r. It should be noted that, in the exemplary embodiment, "minimum enclosing circle" refers to the smallest circle that entirely includes the shape of the penetrating portion 16 inside thereof.

Here, if the penetrating portion 16 has a shape of the minimum circle 21, the light-emitting portion 17 is formed to have a circular shape along with the inner edge portion of the circular shape of the penetrating portion 16, as seen from FIG. 1. Accordingly, light emission is mainly generated in a circular shape in the inner edge portion of the minimum circle 21. Then reduction of the diameter (2r) of the minimum circle 21 and a separation (s) which is the distance between the minimum circles 21 increases the number of the penetrating portions 16 per unit area, thus increasing the light-emitting intensity. However, due to some issues in manufacturing the light-emitting element 10, it is difficult to reduce the diameter (2r) and the separation (s) in the case where the penetrating portion 16 has the shape of the minimum circle 21.

Consequently, in the exemplary embodiment, a perimeter of the penetrating portion 16 as viewed from a direction perpendicular to the surface of the anode layer 12 that serves as the first electrode layer is set longer than a perimeter of the minimum circle 21 that encloses the shape of the penetrating portion 16, and a maximum width of the penetrating portion 16 in the shape on the surface of the anode layer 12 is set in the rage of 0.01 µm to 5 µm. The above-described perimeter is preferably 0.5 µm to 25 µm. Or, the perimeter of the penetrating portion 16 in the shape on the surface of the anode layer 12 is preferably set to 1.15 times to twice the perimeter of the minimum circle that encloses the penetrating portion 16. Further, it is preferable to form the penetrating portions 16 so that the number thereof per 1 mm² on the surface of the substrate 11 is in the range of 10³ to 10⁸. The manufacturability and the light-emitting intensity may be further increased by adjustment performed in these ranges.

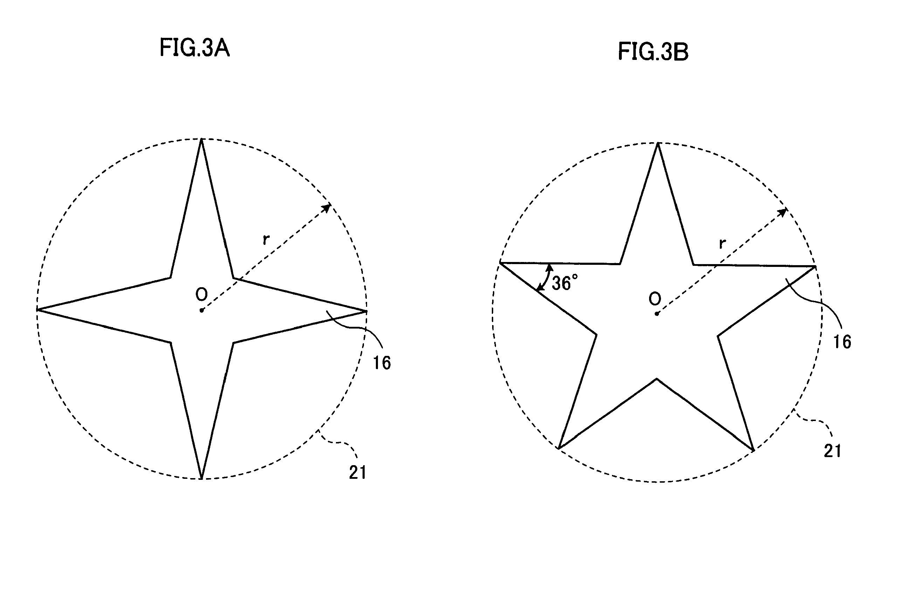

FIGS. 3A and 3B illustrate the shape of the penetrating portion 16 in the light-emitting element 10 according to the exemplary embodiment.
The penetrating portion 16 shown in FIGS. 3A and 3B is in the shape as viewed from a direction of taking out the light in the light-emitting element 10. The penetrating portion 16 shown in FIG. 3A has a shape similar to that of the penetrating portion 16 shown in FIG. 2. This shape of the penetrating portion 16 on the surface of the anode layer 12 is a concave octagon, which is one of the shapes of the concave polygon. The lengths of the sides constituting the concave octagon are approximately the same. The perimeter as a total length of these sides is longer than the perimeter of the minimum circle 21 (namely, the length of the circumference of the circle) that encloses the concave octagon.

Further, in the case of the penetrating portion 16 shown in FIG. 3B, the shape of the penetrating portion 16 is a concave decagon, which is one of the shapes of the concave polygon, and is a so-called star shape. The apex angle at an apex of the convex portion in the concave decagon is set to 36°. Moreover, the lengths of the sides constituting the concave decagon are approximately the same. The perimeter as a total length of these sides is longer than the perimeter of the minimum circle 21 that encloses the concave decagon.

It should be noted that, in the exemplary embodiment, "concave polygon" refers to a polygon that includes at least one interior angle of not less than 180°. In the case where the shape of the concave polygon is employed as the shape of the penetrating portion 16, the concave polygon has preferably 8 or more apexes. Provided with 8 or more apexes, the perimeter of the concave polygon is apt to be longer than the perimeter of the minimum circle 21 that encloses the concave polygon.

By forming the penetrating portion 16 as shown in FIGS. 3A and 3B, the light-emitting area inside the penetrating portion 16 is increased compared to the case where the penetrating portion 16 is simply formed in the circular shape. Therefore, when the constant current is applied to the light-emitting element 10, the amount of the current per light-emitting unit area is decreased compared to the case of the circular shape. Accordingly, it is possible to reduce the current density in the penetrating portion 16. Reduction of the current density enables a current light-emitting efficiency, which is a light-emitting efficiency with respect to the current, to be improved, and also enables the voltage applied to the light-emitting element 10 to be reduced. As a result, it becomes possible to increase the light-emitting intensity without reducing the separation (s) (refer to FIG. 2), and thereby the area of the light-emitting surface is efficiently utilized. Further, due to the increased light-emitting area in the penetrating portion 16, efficiency of dissipating heat generated in the light-emitting portion 17 is also increased. Consequently, the life-time of the light-emitting element 10 is readily extended. Moreover, by forming the penetrating portion 16 in the shape of the concave polygon, it is possible to take out the light generated in the light-emitting portion 17 to the outside efficiently, and to still further improve the light-emitting efficiency.

In addition, approximately the same length of the sides further makes it possible to suppress charge concentration at a specific location. It should be noted that the approximately the same length of the sides does not mean the same length in a strict sense, but means that the sides may be roughly the same length.
Moreover, in the exemplary embodiment, an index referred to as "edge density" may be used to compare the perimeter of the shape of the penetrating portion 16 as viewed from the direction perpendicular to the surface of the anode layer 12 that serves as the first layer with the perimeter of the minimum circle 21 that encloses the shape.

The edge density represents a total length of edges of the penetrating portion 16 that exist in unit area of a substrate surface, namely, a total of the perimeters per unit area. By setting the edge density as high as possible (preferably, not less than 1 µm/µm²), the maximum luminance and the light-emitting efficiency can be still higher, and the voltage at the time of the maximum luminance can be kept low.

For example, in the case where the penetrating portions 16 each having the circular shape are arranged as shown in FIG. 2, since a unit of repetition in the arrangement of the penetrating portions 16 is an equilateral triangle, the perimeter that belongs to the inside of the equilateral triangle is calculated. In the case of the penetrating portion 16 having the circular shape, the perimeter of the circle that belongs to an angle portion of the equilateral triangle is 1/6 of the perimeter of the circle. Since the equilateral triangle has three angles and the radius of the circle is r, the perimeter of the circular shape that belongs to the inside of the equilateral triangle is: 3 x (1/6) x (perimeter) = nr.

Then, the area of the equilateral triangle is, because the length of one side is p, √3p²/4. Accordingly, the edge density, which is the length of the edge of the penetrating portion 16 per unit area, is 4√3πr/(3p²), and can be approximated to 7.26 r/p².

The edge density is calculated by the concave polygon shown in FIGS. 3A and 3B. First, in the case of the concave octagon shown in FIG. 3A, the length of one side is 4/5 of r, namely, 4r/5; therefore the edge density is 64√3r/(15p²). This can be approximated to 7.39r/p².

In the case of the concave decagon shown in FIG. 3B, the edge density is 20√3(3-√/5)r sin72°/(3p²). This can be approximated to 8.39r/p².
Accordingly, the edge density is larger than 7.26r/p² in both cases, and thereby the perimeter of the shape of the penetrating portion 16 as viewed from the light taking-out side is longer than the perimeter of the minimum circle 21 that encloses the shape.

It should be noted that, in the case where the shape of the penetrating portion 16 as viewed from the perpendicular to the surface of the anode layer 12 that serves as the first electrode layer is formed to be a convex polygon, not to be the concave polygon as described above, the perimeter of the shape of the penetrating portion 16 as viewed from the perpendicular to the surface of the anode layer 12 that serves as the first electrode layer cannot be longer than the perimeter of the minimum circle 21 that encloses the shape.
For example, assuming that the convex polygon is an equilateral triangle and the radius of a minimum circle 21 that encloses the equilateral triangle is r, the edge density is 6r/p². Further, in the case of assuming that the convex polygon is a square, the edge density is 8√6r/(3p²). This can be approximated to 6.53r/p². In both cases, the edge density is less than 7.26r/p², which is the edge density of the circular shape. If the number of sides of the convex polygon is increased, the edge density approaches the edge density of the minimum circle 21 that encloses the convex polygon, but cannot exceed thereof.

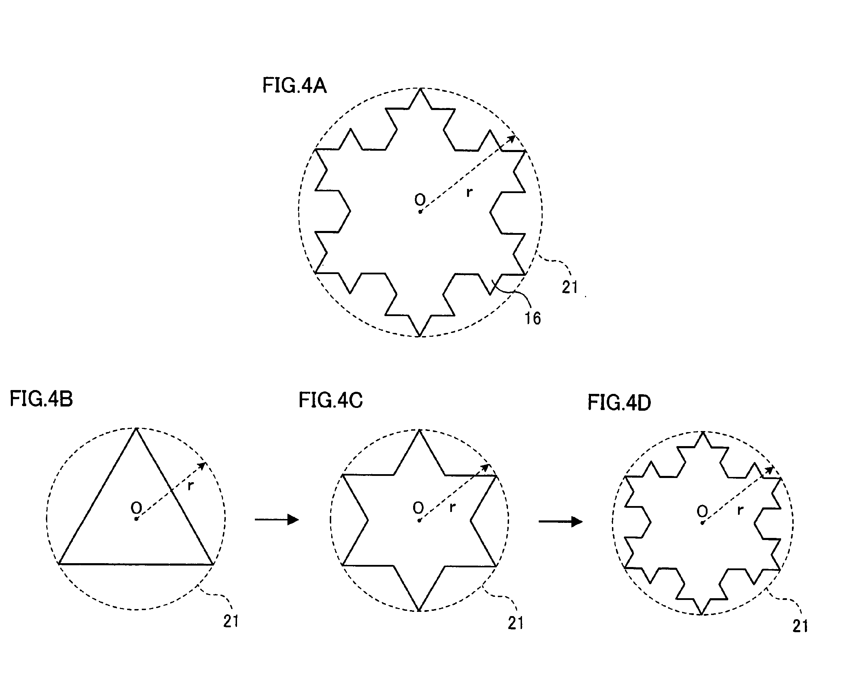

FIG. 4A illustrates another shape of the penetrating portion 16 in the light-emitting element 10 according to the exemplary embodiment.
The shape of the penetrating portion 16 on the surface of the anode layer 12 as shown in FIG. 4A is a shape having a fractal structure.
This shape appears midway through modification of each of three line segments constituting respective sides of the equilateral triangle into a Koch curve.

FIGS. 4B to 4D show a method of forming this shape. First, the method starts with a shape of an equilateral triangle (refer to FIG. 4B). Next, each of three line segments constituting the sides of the equilateral triangle is divided into three equal parts, and another equilateral triangle which has two dividing points as apexes is formed (refer to FIG. 4C). Consequently, a shape constituted by twelve sides is formed. The lengths of these twelve sides are all the same, and a total thereof is 4/3 times the perimeter of the original equilateral triangle. Thereafter, with respect to each of these twelve sides, the operation similar to that shown in FIG. 4B is further performed (refer to FIG. 4D). Accordingly, the shape shown in FIG. 4A that has forty-eight sides is formed. The lengths of these forty-eight sides are all the same, and a total thereof is 4/3 x 4/3, namely, 16/9 times the perimeter of the original equilateral triangle.

With respect to the shape thus formed, in the exemplary embodiment, the equilateral triangle shown in FIG. 4B, which is the original shape, is referred to as a first generation, the shape shown in FIG. 4C is referred to as a second generation, and the shape shown in FIG. 4D is referred to as a third generation. Each of these shape has self-similarity in which enlargement of each part results in a shape similar to a shape of the whole.

Here, in the shape shown in FIG. 4C, by calculation of the edge density on the assumption that the radius of the minimum circle 21 that enclose the shape is r, the result is 8r/p², thus exceeding 7.26r/p², which is an edge density of the minimum circle 21.

Further, with respect to the shape shown in FIG. 4A (FIG. 4D), by calculation of the edge density on the assumption that the radius of the minimum circle 21 that enclose the shape is r, the result is 32r/(3p²). This can be approximated to 10.67r/p², thus further increasing the edge density.
It should be noted that, in the shapes having the fractal structures shown in FIGS. 4B to 4D, the equilateral triangle is a starting shape and the second and third generations thereof are shown, but not limited thereto. For example, the starting shape may be a square, an equilateral pentagon or an equilateral hexagon. Further, the shape of the penetrating portion 16 as viewed from the direction perpendicular to the surface of the anode layer 12 that serves as the first electrode layer may preferably be a shape capable of being formed in the second to fourth generations in terms of easiness in manufacturing the penetrating portion 16.

It should be noted that it is preferable to employ the concave polygon in which each side has the same length or the shape having the fractal structure from the viewpoint of suppressing the charge concentration on a specific location inside the penetrating portion 16, but not limited thereto.

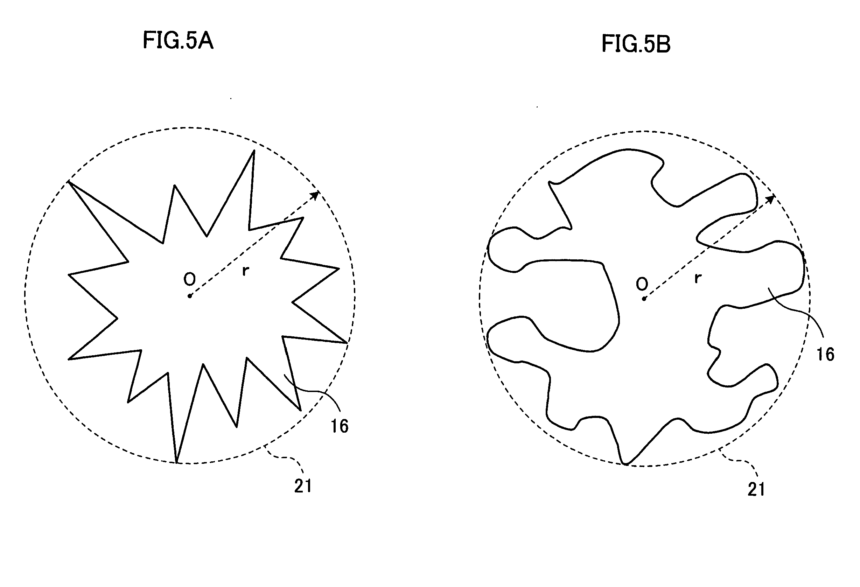

FIGS. 5A and 5B further illustrate different shapes of the penetrating portion 16 in the light-emitting element 10 in the exemplary embodiment.
The shape of the penetrating portion 16 shown in FIG. 5A is a concave polygon; however, the length of each side is not equal, but is varied. Even in such a shape, the perimeter of the shape can be longer than the perimeter of the minimum circle 21 that encloses the shape.

Moreover, in the aforementioned examples, each shape is formed with plural line segments, but not limited thereto and may be configured with curved lines.
The shape of the penetrating portion 16 shown in FIG. 5B illustrate an example of such a case, in which the shape of the penetrating portion 16 is configured with random curved lines. The perimeter of the shape is longer than the perimeter of the minimum circle 21 that encloses the shape.
It should be noted that, in the shape of the penetrating portion 16 described so far, there is a possibility that the charge concentration occurs at the apex portions. To prevent the charge concentration at these portions, for example, it can be considered that the shape of the penetrating portion 16 on the surface of the anode layer 12 is formed as a concave polygon in which the apex portions thereof are chamfered.

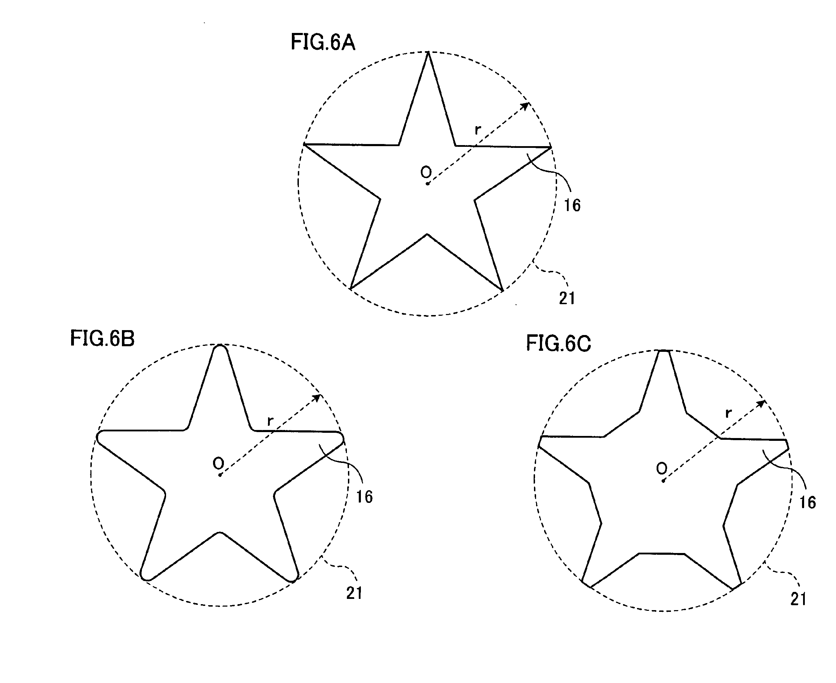

FIGS. 6A to 6C illustrate two chamfering methods for the concave decagon.
First, FIG. 6B shows a case where each of the apexes of the concave decagon shown in FIG. 6A is chamfered by round chamfering. By this chamfering, each apex is smoothly rounded like an arc. FIG. 6C shows a case where each apex of the concave decagon shown in FIG. 6A is chamfered. This chamfering makes each apex straightly rounded. In both cases, the shapes of the apex portions are smoothed compared to those before chamfering, thus capable of suppressing the charge concentration on these parts. It should be noted that, in the examples shown in FIGS. 6B and 6C, chamfering is performed on all apex portions; however, it is particularly preferable to perform chamfering on convex portions among the apex portions. This is because charge concentration is apt to occur in the convex portion due to an acute angle thereof, and therefore, the charge concentration may be suppressed more efficiently by chamfering this portion.

The light-emitting portion 17 is provided to cover at least from the anode layer 12 to the cathode layer 14 on the inner surface of the penetrating portion 16. In the exemplary embodiment, a light-emitting material which emits light upon application of a voltage is provided in contact with a surface covering at least the aforementioned both electrode layers on the inner surface of the penetrating portion 16 as described above. Accordingly, the light-emitting portion 17 is formed on the inner surface of the penetrating portion 16 so as to form the cavity 18. As the light-emitting mechanism in the light-emitting portion 17, for example, a mechanism may be provided in which holes injected from the anode layer 12 and electrons injected from the cathode layer 14 are recombined, and thereby light emission occurs.

As a material of the light-emitting portion 17, either an organic material or an inorganic material may be used. Either low-molecular compound or high-molecular compound may be used as long as it is an organic compound, and examples may include light-emitting low-molecular compound or light-emitting high-molecular compound described in Oyo Butsuri (Applied Physics), Yutaka Ohmori, Vol. 70, No. 12, pages 1419-1425 (2001).
However, in the exemplary embodiment, a material having an excellent coating property is preferred. That is, in the structure of the light-emitting element 10 in the exemplary embodiment, for stable light emission of the light-emitting portion 17 in the penetrating portion 16, it is preferable that the light-emitting portion 17 is uniformly in contact with the inner surface of the penetrating portion 16 to be formed in a uniform thickness, in other words, a coverage property thereof is improved. By use of a material having an excellent coating property, it is possible to suppress variations in luminance of light emitted from the penetrating portion 16.

Further, to uniformly form the light-emitting portion 17 in the penetrating portion 16, it is preferable to employ a coating method. In the coating method, it is easy to fill in the penetrating portion 16 with a solution containing the light-emitting material, thereby capable of forming a layer even on a surface having asperities with an increased coverage property. In the coating method, high-molecular organic materials having mainly a weight average molecular weight of 1,000 to 2,000,000 are preferably used to improve a coating property. Moreover, to improve the coating property, it is possible to add additives for improving the coating property such as a leveling agent and a defoaming agent, or to add a binder resin having low charge trapping capability.

Specific examples of material having an excellent coating property include: arylamine having a predetermined structure with a molecular weight of 1,500 or more to 6,000 or less disclosed in Japanese Patent Application Laid Open Publication No. 2007-86639; and a predetermined high molecular phosphor disclosed in Japanese Patent Application Laid Open Publication No. 2000-34476.
Among the materials having excellent coating property, a light-emitting high molecular compound is preferable in terms of simplification of manufacturing process of the light-emitting element 10, and a phosphorescent light-emitting compound is preferable in terms of high light-emitting efficiency. Accordingly, a phosphorescent light-emitting high molecular compound is particularly preferable. It should be noted that it is possible to mix plural materials or to add a low molecular light-emitting material (for example, molecular weight of not more than 1000) within a scope which does not impair the coating property. On this occasion, an amount of adding the low molecular light-emitting material is preferably not more than 30% by mass.
Further, the light-emitting high molecular compound can be classified into a conjugated light-emitting high molecular compound and a non-conjugated light-emitting high molecular compound; however, among these, the non-conjugated light-emitting high molecular compound is preferred.
From the aforementioned reasons, as the light-emitting material used in the exemplary embodiment, a phosphorescent light-emitting non-conjugated high molecular compound (a light-emitting material which is a phosphorescent light-emitting high molecular compound and also a non-conjugated light-emitting high molecular compound) is especially preferable.

The light-emitting portion 17 of the light-emitting element 10 according to the present invention preferably includes at least the phosphorescent light-emitting polymer (phosphorescent light-emitting material), on molecule of which contains a phosphorescent light-emitting unit that emits phosphorescent light and a carrier transporting unit that transports a carrier. The phosphorescent light-emitting polymer is obtained by copolymerizing a phosphorescent light-emitting compound having a polymerizing substituent and a carrier transporting compound having a polymerizing substituent. The phosphorescent light-emitting compound is a metal complex containing a metallic element selected from a group of iridium (Ir), platinum (Pt) and gold (Au), and especially, an iridium complex is preferable. The examples of phosphorescent light-emitting polymer are compounds disclosed in Japanese Patent Application Laid Open Publication No. 2003-342325.

The light-emitting portion 17 of the light-emitting element 10 according to the exemplary embodiment preferably contains the above-described phosphorescent light-emitting compound, however, a hole transporting compound or an electron transporting compound may be contained so as to supplement a carrier transporting property of the light-emitting portion 17. Examples of the hole-transporting compound used for the aforementioned purpose include low molecular triphenylamine derivatives such as: TPD (N,N'-dimethyl-N,N'-(3-methylphenyl)-1,1'-biphenyl-4,4'diamine); α-NPD (4,4'-bis[N-(1-naphthyl)-N-phenylamino]biphenyl; and m-MTDATA (4,4',4"-tris(3-methylphenylphenylamino)triphenylamine. In addition, examples also include: polyvinylcarbazole; triphenylamine derivative-based high-molecular compound polymerized by introducing a polymerizable functional group; a polymer compound having a triphenylamine skeleton disclosed in Japanese Patent Application Laid Open Publication No. 8-157575; polyparaphenylenevinylene; and polydialkylfluorene. Further, examples of the electron-transporting compound include low molecular materials such as: a quinolinol derivative metal complex, for example, trisquinolinolato aluminum (Alq3); an oxadiazole derivative; a triazole derivative; an imidazole derivative; a triazine derivative; and a triarylborane derivative. The examples further include known electron transporting compound such as the aforementioned low-molecular electron-transporting compound polymerized by introducing the polymerizable functional group, for instance, polyPBD disclosed in Japanese Patent Application Laid Open Publication No. 10-1665.

The light-emitting element described above in detail is not limited to the light-emitting element 10 as shown in FIG. 1 (the cavity 18 is formed by providing the light-emitting material while the light-emitting portion 17 is in contact with the penetrating portion 16, and is formed so that a bottom portion thereof is located close to a bottom portion of the penetrating portion 16).

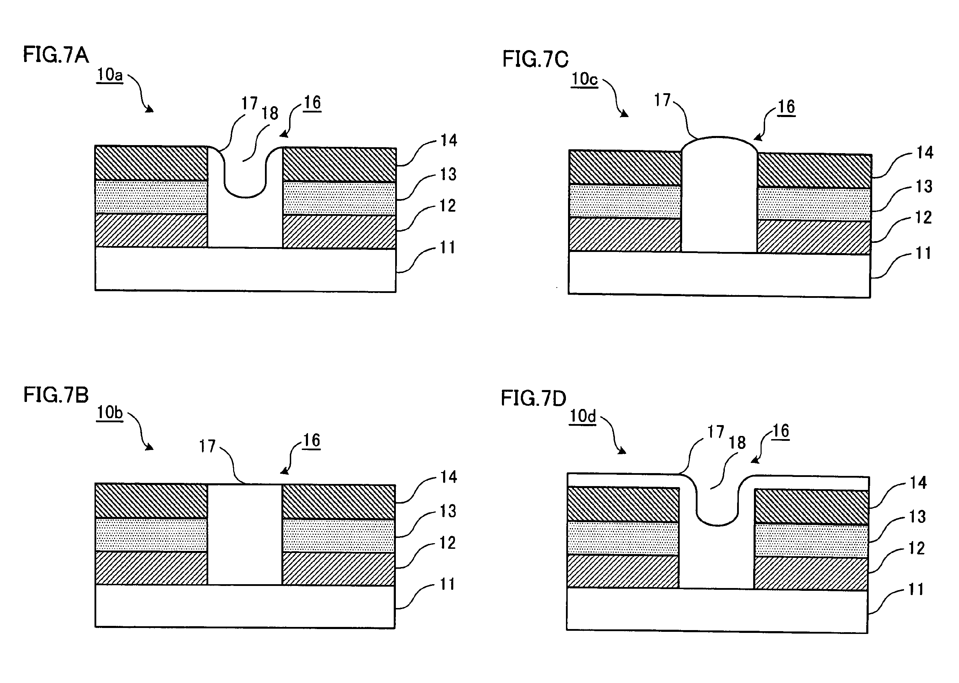

FIGS. 7A to 7D illustrate other modes of the shape of the light-emitting portion 17.
In a light-emitting element 10a shown in FIG. 7A, the cavity 18 has a shallow depth and the bottom portion of the cavity 18 is formed so as to be positioned closer to a vertex of the penetrating portion 16 than a bottom portion thereof. Further, in a light-emitting element 10b shown in FIG. 7B, the cavity 18 is not formed, and the entire penetrating portion 16 is filled with the light-emitting portion 17, a top surface of which coincides with a top surface of the cathode layer 14. Moreover, in a light-emitting element 10c shown in FIG. 7C, the cavity 18 is not formed, the entire penetrating portion 16 is filled with the light-emitting portion 17 and a top surface of the light-emitting portion 17 has a convex shape. Still further, in a light-emitting element 10d shown in FIG. 7D, the cavity 18 is formed but has a shallow depth, and a bottom portion of the cavity 18 is formed to be closer to a vertex portion of the penetrating portion 16 than a bottom portion thereof, and in addition, the light-emitting portion 17 is not only formed inside the penetrating portion 16, but also extended on the top surface of the cathode layer 14.
In the light-emitting elements 10a, 10b, 10c and 10d shown in FIGS. 7A, 7B, 7C and 7D, respectively, the light emitted from the light-emitting portion 17 is propagated inside the light-emitting portion 17, and is able to be taken out in both directions of the substrate 11 and the cathode layer 14 in the same manner as in the aforementioned light-emitting element 10.

The shape of the light-emitting portion 17 described with reference to FIG. 1 and FIGS. 7A to 7D can be selected by, for example, cross-sectional structure of the anode layer 12 and the cathode layer 14.
For example, as in the light-emitting element 10 described with reference to FIG. 1, in the case where the cathode layer 14 is recessed by the penetrating portion 16 and is opened at the upper portion, on the assumption that the substrate 11 is on a lower side and an opposite side of the substrate 11 is on an upper side, it is preferable to form the cavity 18. On the other hand, in the case where the structure in which the light-emitting portion 17 is covered with the cathode layer 14, the cathode layer 14 is formed after the light-emitting portion 17 is formed. Therefore, it is preferable to form the small cavity 18 or not to form the cavity 18 for improving the coverage property in forming the cathode layer 14.

In the light-emitting elements 10, 10a, 10b, 10c and 10d described with reference to FIG. 1 and FIGS. 7A to 7D, the penetrating portion 16 is formed to be recessed into the anode layer 12, the dielectric layer 13 and the cathode layer 14, however, the structure is not limited thereto. For light emission in the light-emitting portion 17, it is required at least that the dielectric layer 13 is penetrated by the penetrating portion 16, and the penetrating portion 16 need not penetrate the other layers.

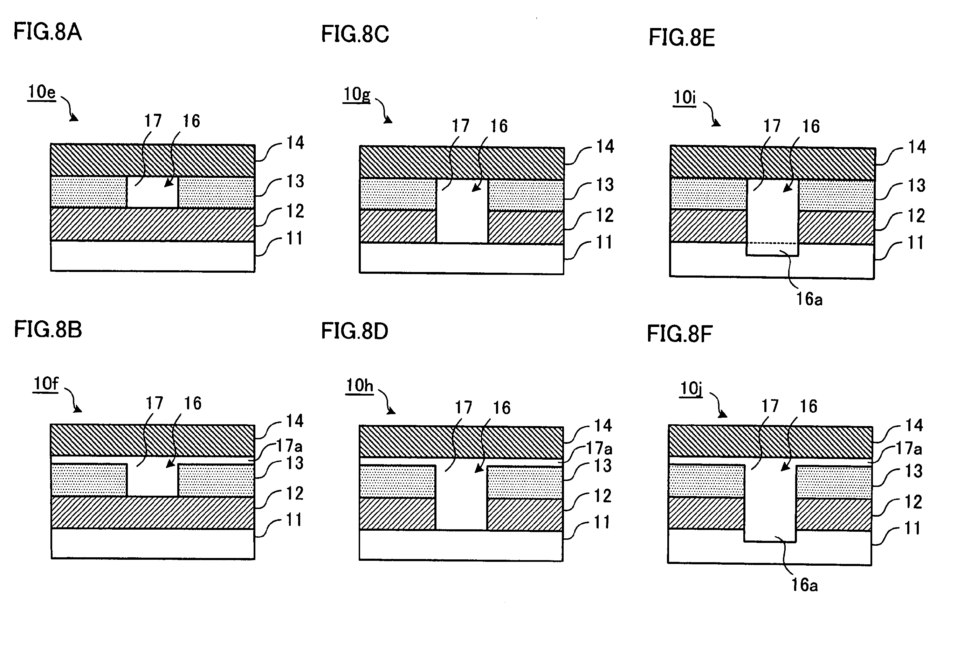

FIGS. 8A to 8F illustrate various modes of the penetrating portion 16 in the light-emitting element according to the present invention.

A light-emitting element 10e shown in FIG. 8A is a case where the penetrating portion 16 penetrates the dielectric layer 13, but does not penetrate the anode layer 12 and the cathode layer 14. In the light-emitting element 10e, a light-emitting material constituting the light-emitting portion 17 fills in the penetrating portion 16. Accordingly, the cathode layer 14 is formed in a planar state on the top surfaces of the dielectric layer 13 and the penetrating portion 16.

In a light-emitting element 10f shown in FIG. 8B, similar to the light-emitting element 10e, the penetrating portion 16 penetrates the dielectric layer 13 but does not penetrate the anode layer 12 and the cathode layer 14. However, the light-emitting material constituting the light-emitting portion 17 not only fills in the penetrating portion 16, but also extends over the top surface of the dielectric layer 13 to form an extension portion 17a. Accordingly, the cathode layer 14 is formed in a planar state on the top surfaces of the penetrating portion 16 and the extension portion 17a.

Further, a light-emitting element 10g shown in FIG. 8C indicates a case where the penetrating portion 16 penetrates the anode layer 12 and the dielectric layer 13, but does not penetrate the cathode layer 14. Similar to the light-emitting element 10e, in the case of the light-emitting element 10g, the penetrating portion 16 is filled with the light-emitting material constituting the light-emitting portion 17, and the cathode layer 14 is formed in a planar state on the top surfaces of the dielectric layer 13 and the penetrating portion 16.

A light-emitting element 10h shown in FIG. 8D indicates a case where the extension portion 17a, which is constituted by the light-emitting material same as that of the light-emitting element 10f, is formed in the light-emitting element 10g.

Further, in a light-emitting element 10i shown in FIG. 8E, similar to the light-emitting element 10g, the penetrating portion 16 penetrates the anode layer 12 and the dielectric layer 13, but does not penetrate the cathode layer 14. However, the light-emitting element 10i is different from the light-emitting element 10g in the point that a dent portion 16a, which is formed by extending the penetrating portion 16 into the substrate 11, is further provided. By forming the dent portion 16a, the light emitted from the light-emitting portion 17 easily enters into the substrate 11. Accordingly, effect of improving light extraction efficiency to the outside is produced.
A light-emitting element 10j shown in FIG. 8F indicates a case where the extension portion 17a constituted by the light-emitting material is formed in the light-emitting element 10i.

In the aforementioned light-emitting elements 10e to 10j, and in the case where the penetrating portion 16 does not penetrate the anode layer 12 or the cathode layer 14 and the light is desired to be taken out in a direction of that layer, it is required that the anode layer 12 or the cathode layer 14 is transparent with respect to a wavelength region of the light emitted from the light-emitting portion 17.

It should be noted that, in the aforementioned light-emitting elements 10 and 10a to 10j, description is given with the example in which the substrate 11 side is assumed to be a lower side, the anode layer 12 and the cathode layer 14 are formed on a lower side and an upper side, respectively, facing each other with the dielectric layer 13 interposed therebetween. However, the structure is not limited thereto and the anode layer 12 and the cathode layer 14 may be replaced with each other. That is, in the case where the substrate 11 side is assumed to be a lower side, it may be possible to form the cathode layer 14 on the lower side and the anode layer 12 on an upper side to face the cathode layer 14 with the dielectric layer 13 interposed therebetween.

Next, description will be given to a manufacturing method of the light-emitting element according to the present invention taking the case of the light-emitting element 10 described with reference to FIG. 1 as an example.

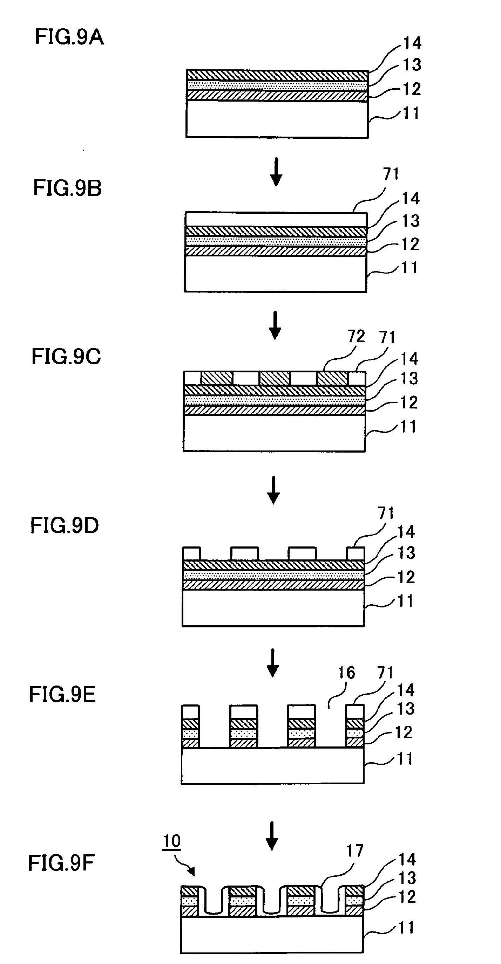

FIGS. 9A to 9F illustrate the manufacturing method of the light-emitting element 10 to which the exemplary embodiment is applied. On the substrate 11, the anode layer 12, the dielectric layer 13 and the cathode layer 14 are laminated in this order (refer to FIG. 9A). These layers may be formed by methods such as a resistance heating evaporation method, an electron beam deposition method, a sputtering method, an ion plating method and a chemical vapor deposition method (CVD). In the case where such layers can be formed by the application of a solution containing the material of each layer onto the substrate and drying thereof, methods such as a spin coating method, a dip coating method, an inkjet printing method, a printing method, a spray coating method and a dispenser printing method may be adopted. In the case where the cathode buffer layer is to be provided, the layer may be formed by the similar methods.
Moreover, by executing a surface treatment of the anode layer 12 after forming thereof, performance of a layer overcoating the anode layer 12 (adhesive property to the anode layer 12, surface smoothness, reducibility of barrier to hole injection and the like) may be improved. Examples of methods for the surface treatment include high-frequency plasma treatment, sputtering treatment, corona treatment, UV ozone irradiation treatment, ultraviolet light irradiation treatment and oxygen plasma treatment.

Further, instead of or in addition to executing the surface treatment of the anode layer 12, an effect similar to the surface treatment may be expected by forming a not-shown anode buffer layer. In the case where the anode buffer layer is formed by a wet process, the layer may be formed by a spin coating method, a casting method, a micro gravure coating method, a gravure coating method, a bar coating method, a roller coating method, a wire-bar coating method, a dip coating method, a spray coating method, a screen printing method, a flexo printing method, an offset printing method or an ink-jet printing method.

The compounds used for layer formation by the wet processes are not particularly limited as long as the compounds show good adhesion to the anode layer 12 and the light-emitting compounds contained in the light-emitting portion 17. Examples thereof include conductive polymers such as a mixture of poly-3,4-ethylenedioxythiophene (PEDOT) and poly(styrenesulfonic acid) and a mixture of polyaniline (PANI) and poly(styrenesulfonic acid). Organic solvents such as toluene and isopropyl alcohol may be added to the conductive polymers. Further, the conductive polymers may contain a third component such as surfactant. The surfactants used herein may contain a group selected from alkyl groups, alkylaryl groups, fluoroalkyl groups, alkylsiloxane groups, sulfates, sulfonates, carboxylates, amides, betaine structures and quaternary ammonium groups. Fluoride-based non-ionic surfactants may also be used.

Further, in the case where the anode buffer layer is formed by dry process, the layer may be formed by a plasma treatment disclosed as an example in Japanese Patent Application Laid Open Publication No. 2006-303412. In addition, the layer may be formed by methods for forming layers of simple metal substances, metal oxides and metal nitrides. Specific examples thereof include an electron beam deposition method, a sputtering method, a chemical reaction method, a coating method and a vacuum deposition method.

Next, each of the layers formed in the step of FIG. 9A is processed to form the penetrating portion 16, which may be formed by, for example, a method using lithography. To form the penetrating portion 16, first, a resist solution is applied on the cathode layer 14 and then an excess resist solution is removed by spin coating or the like to form a resist layer 71 (refer to FIG. 9B).

Thereafter, the resist layer 71 is covered with a mask (not shown), in which a predetermined pattern for forming the penetrating portions 16 is rendered, and is exposed with ultraviolet light (UV), an electron beam (EB) or the like. In the pattern of the mask, aperture portions each having a shape corresponding to that of the penetrating portion 16 are regularly arranged. As a result of the exposure, a predetermined pattern 72, in which shapes of the penetrating portions 16 are regularly arranged, is formed in the resist layer 71 (refer to FIG. 9C).

Here, if exposure at the same magnification (for example, contact exposure or proximity exposure) is performed, a pattern of the penetrating portions 16 at the same magnification with the mask pattern may be formed. If exposure at a reduced magnification (for example, exposure using a stepper) is performed, a pattern of the penetrating portions 16 at the reduced magnification compared to the mask pattern may be formed.

Further, at the time of exposure, by performing exposure with an exposure device which is intentionally defocused, an image of the mask projected on the resist layer 71 is caused to become blurred. Chamfering of the pattern of penetrating portions 16 can be executed in this way. That is, for example, the pattern of the penetrating portions 16 shown in FIG. 6B or 6C may be formed by using a mask that is originally to form the pattern of the penetrating portions 16 shown in FIG. 6A.

Upon removing exposed portions of the resist layer 71 by use of a developing solution, portions of the resist layer 71 corresponding to the pattern 72 are removed (refer to FIG. 9D).

Next, bare portions of the cathode layer 14 are removed by etching, and the penetrating portions 16 are formed to penetrate each layer formed in the step shown in FIG. 9A (refer to FIG. 9E). As the etching, either dry etching or wet etching may be used. Further, by combining isotropic etching and anisotropic etching, it is possible to control the shape of the penetrating portions 16. Examples of available dry etching include reactive ion etching (RIE) and inductive coupling plasma etching, and examples of available wet etching include a method of immersion in diluted hydrochloric acid, diluted sulfuric acid, or the like. As a result, the penetrating portions 16 are formed with a predetermined shape as described above as viewed from a direction of taking out the light.

It should be noted that the layer to be penetrated by the penetrating portion 16 can be selected by adjusting etching conditions (process time, gas to be used, pressure and substrate temperature) when etching is performed. In other words, it is possible to penetrate the dielectric layer 13 and the cathode layer 14 while leaving the anode layer 12. Further, it is also possible to perform additional etching after removing the anode layer 12 to form the dent portions 16a described with reference to FIGS. 8E and 8F.

Moreover, the steps shown in FIGS. 9B to 9D can be performed by a method of nanoimprinting.
Specifically, after forming the resist layer 71 as shown in FIG. 9B, a mask in which predetermined convex patterns to form the pattern 72 are rendered is pressed against the resist layer 71 with pressure. By applying at least one of heat and light to the resist layer surface in this state, photoresist is cured. Next, the mask is removed, and thereby the pattern 72, which is a pattern of the penetrating portions 16 corresponding to the convex patterns, is formed on a surface of the photoresist. Subsequently, the penetrating portions 16 can be formed by performing the aforementioned etching.

Next, the residual resist layer 71 is removed by using a resist removing solution to form the light-emitting portion 17, thus producing the organic electroluminescent element 10 (refer to FIG. 9F). To form the light-emitting portion 17, the above-described coating method is adopted. First, an ink in which the light-emitting material constituting the light-emitting portion 17 is dispersed into a predetermined solvent such as an organic solvent and water is applied. To perform coating, various methods such as a spin coating method, a spray coating method, a dip coating method, an ink jet method, a slit coating method, a dispenser method and a printing method may be used. After the coating is performed, the ink is dried by heating or air-purging, and thereby the light-emitting material adheres to the inner surface of the penetrating portion 16 to form the light-emitting portion 17.

After a series of these steps is performed, to protect the light-emitting element 10 from the outside environment and to allow for long and stable use of the light-emitting element 10, a protective layer and/or a protective cover (not shown) is preferably provided. Polymer compounds, metal oxides, metal fluorides, metal borides, silicon compounds such as silicon nitrides and silicon oxides may be used to form the protective layers. A lamination thereof may also be used. The protective covers may be glass plates, plastic plates having a low water permeable surface, and metals. It is preferable that the protective cover is bonded to the substrate of the element by a thermosetting resin or a photocurable resin to be sealed. The use of spacers is preferable since spaces may be provided and the prevention of scratches on the light-emitting element 10 is facilitated. Filling the spaces with inert gases such as nitrogen, argon and helium prevents the oxidation of the cathode layer 14 on the upper side. Especially, use of helium is preferable since high thermal conductivity thereof enables heat generated from the light-emitting element 10 upon application of a voltage to be effectively transmitted to the protective cover. In addition, the placement of desiccants such as barium oxide in the spaces makes it easily possible to suppress water that is adsorbed in the light-emitting element 10 during the above-described series of manufacturing steps from causing damages to the light-emitting element 10.

It should be noted that, to produce the light-emitting elements 10e to 10j described with reference to FIGS. 8A to 8F, the cathode layer 14 is not formed in the step shown in FIG. 9A but is formed after the step shown in FIG. 9F.

Next, description will be given to an image display device equipped with the light-emitting element described in detail above.

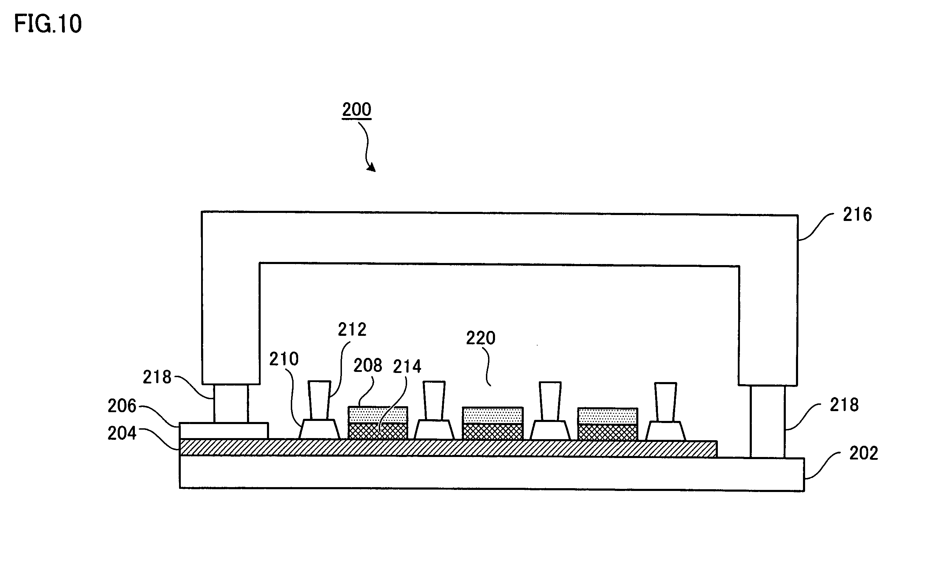

FIG. 10 illustrates an example of the image display device using the light-emitting element according to the exemplary embodiment.
The image display device 200 shown in FIG. 10 is of a so-called passive matrix type and includes: an image display device substrate 202; an anode wiring 204; an auxiliary anode wiring 206; a cathode wiring 208; an insulating film 210; a cathode partition 212; a light-emitting element 214; a shield plate 216; and a sealing material 218.

The image display device substrate 202 may employ a transparent substrate such as a rectangular glass substrate. The thickness of the image display device substrate 202 is not particularly limited; however, the thickness may be, for example, 0.1 mm to 1 mm.
Plural anode wirings 204 are formed on the image display device substrate 202. The anode wirings 204 are arranged in parallel with certain intervals. The anode wiring 204 is configured with a transparent conductive film which may be made of, for example, ITO (indium tin oxide). The thickness of the anode wiring 204 may be set to, for example, 100 nm to 150 nm. The auxiliary anode wiring 206 is formed on an end portion of each of the anode wirings 204. The auxiliary anode wiring 206 is electrically connected to the anode wiring 204. With such a configuration, the auxiliary anode wiring 206 functions as a terminal for connecting to an external wiring on the end portion side of the image display device substrate 202, and accordingly, a current may be supplied from a not-shown drive circuit provided outside to the anode wiring 204 through the auxiliary anode wiring 206. The auxiliary anode wiring 206 may be configured with, for example, a metal film having a thickness of 500 nm to 600 nm.

Plural cathode wirings 208 are also provided on the image display device substrate 202. The plural cathode wirings 208 are arranged in parallel with each other, and each intersecting the anode wirings 204. Aluminum or aluminum alloy may be used for the cathode wiring 208. The thickness of the cathode wiring 208 is, for example, 100 nm to 150 nm. Further, similar to the auxiliary anode wiring 206 for the anode wiring 204, a not-shown auxiliary cathode wiring is provided on an end portion of the cathode wiring 208, and is electrically connected to the cathode wiring 208. Consequently, a current is capable of flowing between the cathode wiring 208 and the auxiliary cathode wiring.
On the image display device substrate 202, the insulating film 210 is formed to cover the anode wirings 204. The aperture portion 220 having a rectangular shape is provided in the insulating film 210 to expose a part of the anode wiring 204. Plural aperture portions 220 are arranged in a matrix on the anode wirings 204. As described later, the light-emitting elements 214 are provided at the aperture portions 220 between the anode wirings 204 and the cathode wirings 208. That is, each aperture portion 220 becomes a pixel. Accordingly, a display region is formed corresponding to the aperture portions 220. Here, the thickness of the insulating film 210 may be set to, for example, 200 nm to 300 nm, and the size of the aperture portion 220 may be set to, for example, 300 µm x 300 µm.

The light-emitting elements 214 are formed at locations corresponding to the positions of the aperture portions 220 on the anode wirings 204. Here, in the light-emitting element 214, the anode layer 12, the dielectric layer 13, the cathode layer 14 and the light-emitting portion 17 are formed directly on the anode wiring 204 since the anode wiring 204 substitutes as the substrate 11 (refer to FIG. 1). The light-emitting element 214 is held between the anode wiring 204 and the cathode wiring 208 at the aperture portion 220. In other words, the anode layer 12 and the cathode layer 14 of the light-emitting element 214 are in contact with the anode wiring 204 and the cathode wiring 208, respectively. The thickness of the organic electrluminescent element 214 may be set to, for example, 150 nm to 200 nm.

On the insulating film 210, plural cathode partitions 212 are formed along the direction perpendicular to the anode wirings 204. The cathode partitions 212 play a role in spatially separating the plural cathode wirings 208 so as to bring the cathode wirings 208 out of conduction with each other. Accordingly, each of the cathode wirings 208 is arranged between the adjacent cathode partitions 212. The size of the cathode partition 212 may be, for example, 2 µm to 3 µm in height and 10 µm in width.
The image display device substrate 202 is bonded to the shield plate 216 with the sealing material 218. This may cause a space where the light-emitting element 214 is provided to be shielded, and may prevent the light-emitting element 214 from deteriorating due to water in air. As the shield plate 216, for example, as a glass substrate having a thickness of 0.7 mm to 1.1 mm may be used.
In the image display device 200 with such a configuration, a current is supplied to the light-emitting element 214 via the auxiliary anode wirings 206 and the not-shown auxiliary cathode wirings from a not-shown driving device to cause the light-emitting element 214 to emit light, thereby causing the penetrating portion 16 to radiate light. By controlling the light-emitting elements 214 corresponding to pixels to emit light or not to emit light, images may be displayed on the image display device 200.

Next, a lighting device using the light-emitting element 10 will be described.

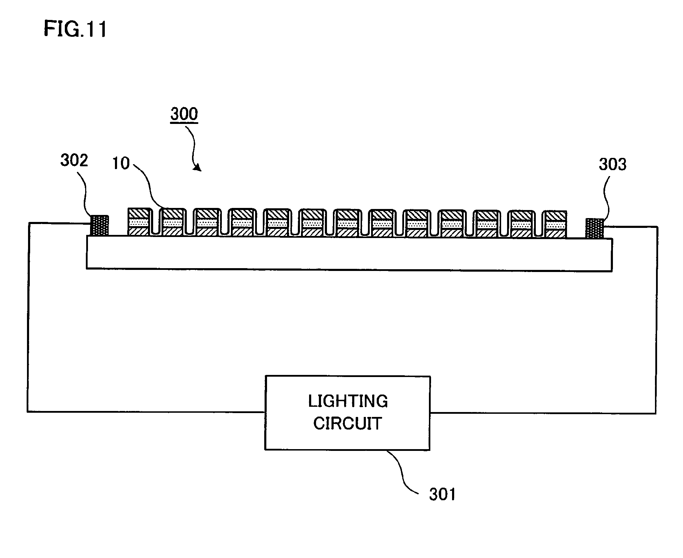

FIG. 11 illustrates an example of the lighting device equipped with the light-emitting element according to the exemplary embodiment.
A lighting device 300 shown in FIG. 11 is configured with: the aforementioned light-emitting element 10; a terminal 302 that is provided adjacent to the substrate 11 (refer to FIG. 1) of the light-emitting element 10 and is connected to the anode layer 12 (refer to FIG. 1); a terminal 303 that is provided adjacent to the substrate 11 (refer to FIG. 1) and is connected to the cathode layer 14 (refer to FIG. 1) of the light-emitting element 10; and a operating circuit 301 that is connected to the terminals 302 and 303 to drive the light-emitting element 10.
The operating circuit 301 has a not-shown DC power supply and a not-shown control circuit inside thereof, and supplies a current between the anode layer 12 and the cathode layer 14 of the light-emitting element 10 via the terminals 302 and 303. The operating circuit 301 drives the light-emitting element 10 to cause the light-emitting portion 17 (refer to FIG. 1) to emit light and the penetrating portion 16 to radiate light, thus utilizing the light for illumination. The light-emitting portion 17 may be configured with the light-emitting material that emits white light, or, it may be possible to provide plural light-emitting elements 10 using a light-emitting material that radiates each of the green light (G), blue light (B) and red light(R), thus making a synthetic light white. It should be noted that, in the lighting device 300 according to the exemplary embodiment, when the light emission is performed with small diameters of the penetrating portions 16 and small intervals therebetween, the light emission seems to be surface emitting to the human eye.

### EXAMPLES

### Example 1

### [Preparation of light-emitting material solution]

A phosphorescent light-emitting high molecular compound (A) as follows was synthesized according to the method disclosed in International Publication No. WO2010/16512. The weight average molecular weight of the high molecular compound (A) was 52000 and the molar ratio of each repeating unit was k:m:n = 6:42:52.

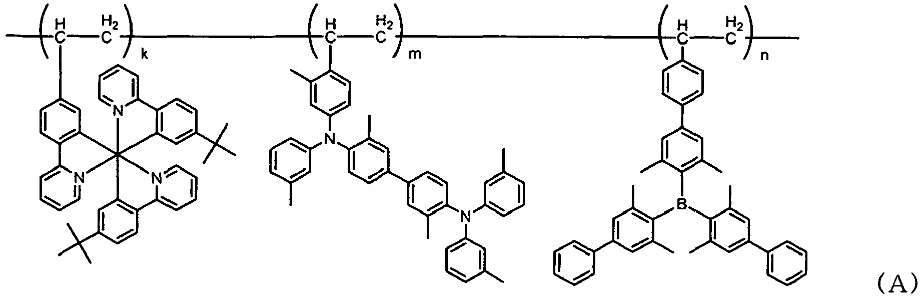

A light-emitting material solution (hereinafter, also referred to as "solution A") was prepared by dissolving 3 parts by weight of the phosphorescent light-emitting high molecular compound (A) in 97 parts by weight of toluene.

### [Preparation of light-emitting element]

As a light-emitting element, the organic light-emitting element 10 shown in FIG. 1 was prepared by the method described below.
Specifically, first, on a glass substrate made of fused quartz (25 mm per side, the thickness of 1mm), an ITO (indium tin oxide) film of 150 nm in thickness, a silicon dioxide (SiO₂) layer of 200 nm in thickness, and an aluminum (Al) layer of 100 nm in thickness were formed by using a sputtering device (E-401s manufactured by Canon ANELVA Corporation). Here, the glass substrate corresponds to the substrate 11. The ITO film, the silicon dioxide layer, and the aluminum layer correspond to the anode layer 12, the dielectric layer 13 and the cathode layer 14, respectively.

Next, a photoresist (AZ1500 manufactured by AZ Electronic Materials) of about 1 µm in thickness is formed by a spin coating method. Then, on a quartz (having a thickness of 3 mm) as a substrate, a mask A corresponding to a pattern in which the penetrating portions 16 having the shape shown in FIG. 3B are arranged as shown in FIG, 2 was produced, and exposure was performed on a scale of 1/5 by use of a stepper exposure device (NSR-1505i6 manufactured by Nikon Corporation). Next, development was executed with 1.2% aqueous solution of TMAH (tetramethyl ammonium hydroxide: (CH₃)₄NOH) for patterning the resist layer. Thereafter, heat at a temperature of 130°C was applied for 10 minutes (postbaking process).
Subsequently, by performing dry etching using a reactive ion etching device (RIE-200iP manufactured by SAMCO Inc.), each layer was processed in order. On this occasion, etching conditions of each layer are as follows.

The etching conditions for the aluminum layer and the ITO film were: using a mixed gas of Cl₂ and SiCl₄ as a reactant gas; and causing a reaction for 8 minutes under a pressure of 1Pa and output bias/ICP = 200/100(W).

The etching conditions for the silicon dioxide (SiO₂) layer were: using CHF₃ as a reactant gas; and causing a reaction for 18 minutes under a pressure of 0.3Pa and output bias/ICP = 50/100 (W).

With the aforementioned dry etching process, the penetrating portion 16 that penetrates the aluminum layer as the cathode layer 14, the silicon dioxide layer as the dielectric layer 13 and the ITO film as the anode layer 12 was formed. Then the residue of the resist was removed by the resist removing solution.
Upon observing the shape of the penetrating portion 16 with an AFM (VN8010 manufactured by KEYENCE CORPORATION), the shape was as shown in FIG. 3B.

Next, the glass substrate was washed by spraying pure water and dried by a spin dryer.
Then the solution A was applied by the spin coating method (spin rate: 3000 rpm), and subsequently, the substrate having the layers thereon was left standing under a nitrogen atmosphere at the temperature of 120°C for an hour to be dried, and thus the light-emitting portion 17 was formed.
The organic light-emitting element 10 was able to be produced by the aforementioned processes.

### Example 2

The organic light-emitting element 10 was produced in the same manner as Example 1 except that the shape pattern of the penetrating portion 16 was changed to the shape of the concave octagon shown in FIG. 3A.

### Example 3

The organic light-emitting element 10 was produced in the same manner as Example 1 except that the shape pattern of the penetrating portion 16 was changed to the shape of the fractal structure shown in FIG. 4A.

### Example 4

The organic light-emitting element 10 was produced in the same manner as Example 1 except that that the shape pattern of the penetrating portion 16 was changed to the shape of the fractal structure shown in FIG. 4A, and further each apex of the shape was round-chamfered. The round chamfering can be performed by adjusting the focus of the stepper exposure device 5 mm deeper (that is, to be focused behind the surface of the photoresist).

### Comparative example 1

The organic light-emitting element was produced in the same manner as Example 1 except that the shape pattern of the penetrating portion 16 was changed to the circular shape.

### Example 5

As an organic light-emitting element, the organic light-emitting element 10f shown in FIG. 8B was prepared by the method described below.
Specifically, first, on a glass substrate made of fused quartz (25 mm per side, the thickness of 1mm), an ITO (indium tin oxide) film of 150 nm in thickness and a silicon dioxide (SiO₂) layer of 200 nm in thickness were formed by using a sputtering device (E-401s manufactured by Canon ANELVA Corporation). Here, the glass substrate corresponds to the substrate 11. The ITO film and the silicon dioxide layer correspond to the anode layer 12 and the dielectric layer 13, respectively.

Next, a photoresist (AZ1500 manufactured by AZ Electronic Materials) of about 1 µm in thickness is formed by a spin coating method. Then, on a quartz (having a thickness of 3 mm) as a substrate, a mask A corresponding to a pattern in which the penetrating portions 16 having the shape of the concave decagon shown in FIG. 3B are arranged as shown in FIG, 2 was produced, and exposure was performed on a scale of 1/5 by use of a stepper exposure device (NSR-1505i6 manufactured by Nikon Corporation). Next, development was executed with 1.2% aqueous solution of TMAH (tetramethyl ammonium hydroxide: (CH₃)₄NOH) for patterning the resist layer. Thereafter, heat at a temperature of 130°C was applied for 10 minutes (postbaking process).

Next, by performing dry etching using a reactive ion etching device (RIE-200iP manufactured by SAMCO Inc.), the silicon dioxide (SiO₂) layer was processed.
On this occasion, the etching conditions for the silicon dioxide layer were: using CHF₃ as a reactant gas; and causing a reaction for 18 minutes under a pressure of 0.3Pa and output bias/ICP = 50/100 (W).
With the aforementioned dry etching process, the penetrating portion 16 that penetrates the silicon dioxide layer as the dielectric layer 13 was formed. Then the residue of the resist was removed by the resist removing solution.
Upon observing the shape of the penetrating portion 16 with an AFM (VN8010 manufactured by KEYENCE CORPORATION), the shape was the concave decagon as shown in FIG. 3B.

Next, the glass substrate was washed by spraying pure water and dried by a spin dryer.

Then the solution A was applied by the spin coating method (spin rate: 3000 rpm), and subsequently, the substrate having the layer thereon was left standing under a nitrogen atmosphere at the temperature of 120°C for an hour to be dried, and thus the light-emitting portion 17 was formed.
Then, an aluminum (Al) layer of 150 nm in thickness was formed as the cathode layer 14 by using a sputtering device (E-401s manufactured by Canon ANELVA Corporation).
The organic light-emitting element 10f was able to be produced by the aforementioned processes.

### Comparative example 2

The organic light-emitting element was produced in the same manner as Example 5 except that the shape pattern of the penetrating portion 16 was changed to the circular shape.

### Example 6

As an organic light-emitting element, the organic light-emitting element 10h shown in FIG. 8D was prepared by changing Example 5 in the following point.
After processing the silicon dioxide (SiO₂) layer by performing dry etching using a reactive ion etching device (RIE-200iP manufactured by SAMCO Inc.), further, the ITO film was processed by etching by use of the same device.
The etching conditions for the ITO film were: using a mixed gas of Cl₂ and SiCl₄ as a reactant gas; and causing a reaction for 8 minutes under a pressure of 1Pa and output bias/ICP = 200/100 (W).
With the aforementioned dry etching process, the penetrating portion 16 that penetrates the silicon dioxide layer as the dielectric layer 13 and the ITO film as the anode layer 12 was formed.
By performing other processes in the same manner as in Example 5, the organic light-emitting element 10h was able to be produced.

### Comparative example 3

The organic light-emitting element was produced in the same manner as Example 6 except that the shape pattern of the penetrating portion 16 was changed to the circular shape.

### Example 7

As an organic light-emitting element, the organic light-emitting element 10j shown in FIG. 8F was prepared by changing Example 6 in the following point.
After processing the silicon dioxide (SiO₂) layer and the ITO film by performing dry etching using a reactive ion etching device (RIE-200iP manufactured by SAMCO Inc.), further, the glass substrate 11 was processed by etching in the depth of 150 nm by use of the same device.
The etching conditions for the glass substrate 11 were: using CHF₃ as a reactant gas; and causing a reaction for 18 minutes under a pressure of 0.3Pa and output bias/ICP = 50/100 (W).
With the aforementioned dry etching process, the dent portion 16a was formed on the glass substrate as the substrate 11 as well as the penetrating portion 16 penetrating the silicon dioxide layer as the dielectric layer 13 and the ITO film as the anode layer 12.
By performing other processes in the same manner as in Example 6, the organic light-emitting element 10h was able to be produced.

### Comparative example 4

The organic light-emitting element was produced in the same manner as Example 7 except that the shape pattern of the penetrating portion 16 was changed to the circular shape.

### Example 8

As an organic light-emitting element, the organic light-emitting element 10h shown in FIG. 8D was prepared by changing Example 6 in the following point.
A titanium (Ti) layer, instead of the ITO film, of 150 nm in thickness was formed as the anode layer 12 by using a sputtering device (E-401s manufactured by Canon ANELVA Corporation). The etching conditions for forming the penetrating portion 16 may be the same as those for the ITO film.

### Comparative example 5

The organic light-emitting element was produced in the same manner as Example 8 except that the shape pattern of the penetrating portion 16 was changed to the circular shape.

### Evaluation method

Evaluation was performed by measuring a perimeter of the penetrating portion 16 and luminance of each organic light-emitting element produced as described above.

### Measurement of perimeter

Based on the image of the AFM (VN8010 manufactured by KEYENCE CORPORATION) observing the shape of the penetrating portion 16, the perimeter was measured. That is, the perimeter of the penetrating portion 16 can be measured by tracing the perimeter of the image of the penetrating portion 16 with a flexible ruler and calculating the length thereof.

### Measurement of luminance

As a voltage is successively applied to the organic light-emitting element, the luminance is increased in response to the voltage rising, and after reaching the maximum value, the luminance decreases due to burning out of the organic light-emitting element. The luminance was measured and the maximum value of the luminance was assumed to be the maximum luminance.
Specifically, a voltage was applied to each organic light-emitting element by a DC power supply (SM2400 manufactured by Keithley Instruments Inc.). The application of the voltage was started with 2V, and the voltage was caused to rise stepwisely by 0.1 V. At this time, the voltage was maintained for a second at each step, during which measurement of the current and the measurement of the luminescence with a brightness meter (BM-9 manufactured by TOPCON CORPORATION) were conducted. Accordingly, a luminescence plot with respect to the voltage and the current may be obtained. The maximum value of the luminance in this plot was assumed to be the maximum luminance.

The evaluation results are shown in Table 1 below. The results of the radius (r), the pitch (p) and the separation (s) described with reference to FIG. 2 are also shown.

**Table 1**

| | Cross-sectional shape of penetretin g portion | Shape pattern of penetratin g portions | r | p | s | Perimeter of minimum enclosing circle | Perimeter of penetrating portion | Increasing rate of perimeter | Perimeter per unit area of light-emitting surface (edge density) | Number of penetrating portions per unit area of light-emitting urface | Maximum luminance ' | Voltage at maximum luminance | Light-emitting efficiency per 1.000cd/m² |
|---|---|---|---|---|---|---|---|---|---|---|---|---|---|
| | | | *µ*m: | *µ*m | *µ*m | *µ*m | *µ*m | times | *µ*m/*µ*m² | number/mm² | cd/m² | V | cd/A |
| Example 1 | FIG. 1 | FIG. 3B | 0.49 | 2.00 | 1.02 | 3.08 | 3.56 | 1.16 | 1.03 | 2.9 × 10⁵ | 19.000 | 13 | 28.9 |
| Example 2 | FIG. 1 | FIG. 3A | 0.50 | 2.00 | 1.00 | 3.14 | 3.75 | 1.20 | 1.08 | 2.9 × 10⁵ | 21.500 | 13 | 27.5 |
| Example 3 | FIG. 1 | FIG. 4A | 0.51 | 2.00 | 0.98 | 3.20 | 4.62 | 1.44 | 1.33 | 2.9 × 10⁵ | 26.000 | 13 | 31.0 |
| Example 4 | FIG. 1 | FIG. 4A + round chamferin g | 0.45 | 2.00 | 1.10 | 2.83 | 4.80 | 1.70 | 1.39 | 2.9 × 10⁵ | 27.500 | 12 | 32.4 |
| Comparative example 1 | FIG. 1 | Circular shape | 0.50 | 2.00 | 1.00 | 3.14 | 3.13 | 1.00 | 0.90 | 2.9 × 10⁵ | 16.000 | 14 | 18.6 |
| Example 5 | FIG. 8B | FIG. 3B | 0.48 | 2.00 | 1.04 | 3.02 | 3.49 | 1.16 | 1.01 | 2.9 × 10⁵ | 41.500 | 8 | 25.5 |
| Comparative example 2 | FIG. 8B | Circular shape | 0.51 | 2.00 | 0.98 | 3.20 | 3.22 | 1.01 | 0.93 | 2.9 × 10⁵ | 32.000 | 8 | 16.1 |
| Example 6 | FIG. 8D | FIG. 3B | 0.50 | 2.00 | 1.00 | 3.14 | 3.63 | 1.16 | 1.05 | 2.9 × 10⁵ | 46.000 | 8 | 30.2 |
| Comparative example 3 | FIG. 8D | Circular shape | 0.52 | 2.00 | 0.96 | 3.27 | 3.20 | 0.98 | 0.92 | 2.9 × 10⁵ | 35.000 | 8 | 21.1 |
| Example 7 | FIG. 8F | FIG. 3B | 0.52 | 2.00 | 0.96 | 3.27 | 3.78 | 1.16 | 1.09 | 2.9 × 10⁵ | 48.000 | 8 | 35.0 |
| Comparative example 4 | FIG. 8F | Circular shape | 0.53 | 2.00 | 0.94 | 3.33 | 3.35 | 1.01 | 0.97 | 2.9 × 10⁵ | 36.000 | 8 | 21.4 |
| Example 8 | FIG. 8D | FIG. 3B | 0.50 | 2.00 | 1.00 | 3.14 | 3.63 | 1.16 | 1.05 | 2.9 × 10⁵ | 50.500 | 8 | 26.9 |
| Comparative example 5 | FIG. 8D | Circular shape | 0.50 | 2.00 | 1.00 | 3.14 | 3.14 | 1.00 | 0.91 | 2.9 × 10⁵ | 38.000 | 8 | 17.3 |

### Example 9

The organic light-emitting element was produced in the same manner as Example 2 except that the radius (r), the pitch (p) and the separation (s) described with reference to FIG. 2 were changed to those as shown in Table 2.

### Comparative example 6

The organic light-emitting element was produced in the same manner as Comparative example 1 except that the radius (r), the pitch (p) and the separation (s) were changed to those as shown in Table 2.

### Example 10

The organic light-emitting element was produced in the same manner as Example 5 except that the radius (r), the pitch (p) and the separation (s) were changed to those as shown in Table 2.

### Comparative example 7

The organic light-emitting element was produced in the same manner as Comparative example 2 except that the radius (r), the pitch (p) and the separation (s) were changed to those as shown in Table 2.

### Example 11

The organic light-emitting element was produced in the same manner as Example 6 except that the penetrating portions 16 were arranged in a lattice pattern.

### Comparative example 8

The organic light-emitting element was produced in the same manner as Comparative example 3 except that the penetrating portions 16 were arranged in a lattice pattern.

### Example 12

The organic light-emitting element was produced in the same manner as Example 7 except that the penetrating portions 16 were arranged in a lattice pattern.

### Comparative example 9

The organic light-emitting element was produced in the same manner as Comparative example 4 except that the shape of the penetrating portion 16 is changed to a square and the penetrating portions 16 were arranged in a lattice pattern.

### Comparative example 10

The organic light-emitting element was produced in the same manner as Comparative example 4 except that the shape of the penetrating portion 16 is changed to an equilateral hexagon and the penetrating portions 16 were arranged in a lattice pattern.

**Table 2**

| | Cross-sectional shape of penetratin g portion | Shape pattern of penetratin g portions | r | p | s | Perimeter of minimum enclosing circlet | Perimeter of penetrating portion | Increasing rate of perimeter | Perimeter per unit area of light-emitting surface (edge density) | Number of penetrating portions per unit area of light-emitting surface | Maximum luminance | Voltage at maximum | Light-emitting efficiency, per 1.000cd/m² |
|---|---|---|---|---|---|---|---|---|---|---|---|---|---|
| | | | *µ*m | *µ*m | *µ*m | *µ*m | *µ*m | times | *µ*m/*µ*m² | number/mm² | cd/m² | V | cd/A |
| Example 9 | FIG. 1 | FIG. 3A | 0.30 | 1.30 | 0.70 | 1.88 | 2.07 | 1.10 | 1.42 | 6.8 × 10⁵ | 26,000 | 13 | 30.0 |
| Comparative example 6 | FIG. 1 | Circular shape | 0.30 | 1.30 | 0.70 | 1.88 | 1.88 | 1.00 | 1.29 | 6.8 × 10⁵ | 17,000 | 14 | 21.9 |
| Example 10 | FIG. 8B | FIG. 3B | 0.30 | 1.30 | 0.70 | 1.88 | 2.18 | 1.16 | 1.49 | 6.8 × 10⁵ | 55,000 | 8 | 28.6 |
| Comparative example 7 | FIG. 8B | Circular shape | 0.30 | 1.30 | 0.70 | 1.88 | 1.88 | 1.00 | 1.29 | 6.8 × 10⁵ | 36,000 | 8 | 19.5 |
| Example 11 | FIG. 8D | FIG. 3B | 0.50 | 2.00 | 1.00 | 3.14 | 3.63 | 1.16 | 0.91 | 2.5 × 10⁵ | 40.000 | 8 | 30.1 |
| Comparative example 8 | FIG. 8D | Circular shape | 0.50 | 2.00 | 1.00 | 3.14 | 3.14 | 1.00 | 0.79 | 2.5 × 10⁵ | 22,500 | 8 | 22.0 |
| Example 12 | FIG. 8F | FIG. 3B | 0.50 | 2.00 | 1.00 | 3.14 | 3.63 | 1.16 | 0.91 | 2.5 × 10⁵ | 41,000 | 8 | 34.2 |
| Comparative example 9 | FIG. 8F | Square | 0.50 | 2.00 | 1.00 | 3.14 | 2.83 | 0.90 | 0.71 | 2.5 × 10⁵ | 27.000 | 8 | 19.8 |
| Comparative example 10 | FIG. 8F | hexagon | 0.50 | 2.00 | 1.00 | 3.14 | 3.00 | 0.95 | 0.75 | 2.5 × 10⁵ | 29,000 | 8 | 18.9 |

### Reference Signs List

- 10: Light-emitting element
- 11: Substrate
- 12: Anode layer
- 13: Dielectric layer
- 14: Cathode layer
- 16: Penetrating portion
- 17: Light-emitting portion
- 18: Cavity
- 21: Minimum circle
- 200: Image display device
- 300: Lighting device

## Claims

1. A light-emitting element comprising:
a substrate;
a first electrode layer, a dielectric layer and a second electrode layer successively laminated on a surface of the substrate;
a plurality of penetrating portions that penetrate at least the dielectric layer and extend from the first electrode layer to the second electrode layer; and
a light-emitting portion that covers at least a portion between the first electrode layer and the second electrode layer on an inner surface of each of the plurality of penetrating portions, wherein
a perimeter of a shape of each of the plurality of penetrating portions on a surface of the first electrode layer is longer than a perimeter of a minimum circle enclosing the shape, and
a maximum width of the shape is in a range of 0.01 µm to 5µm.

2. The light-emitting element according to claim 1, wherein the plurality of penetrating portions also penetrate the first electrode layer.

3. The light-emitting element according to any one of claims 1 and 2, wherein the plurality of penetrating portions also penetrate the second electrode layer.

4. The light-emitting element according to any one of claims 1 to 3, wherein the perimeter of the shape on the surface of the first electrode layer is in a range of 0.5 µm to 25 µm.

5. The light-emitting element according to any one of claims 1 to 4, wherein the perimeter of the shape on the surface of the first electrode layer is 1.15 to 2 times the perimeter of the minimum circle enclosing the shape.

6. The light-emitting element according to any one of claims 1 to 5, wherein the number of the penetrating portions formed on the surface of the substrate per 1 mm² is in a range of 10³ to 10⁸.

7. The light-emitting element according to any one of claims 1 to 6, wherein a total of the perimeters of the penetrating portions on the surface of the substrate per unit area is not less than 1 µm/µm².

8. The light-emitting element according to any one of claims 1 to 7, wherein the shape on the surface of the first electrode layer is a concave polygon.

9. The light-emitting element according to any one of claims 1 to 7, wherein the shape on the surface of the first electrode layer is a concave polygon whose apex portions are chamfered.

10. The light-emitting element according to any one of claims 8 and 9, wherein the concave polygon includes 8 or more apexes.

11. The light-emitting element according to any one of claims 8 to 10, wherein sides of the concave polygon have the same length.

12. The light-emitting element according to any one of claims 1 to 11, wherein the shape on the surface of the first electrode layer has a fractal structure.

13. The light-emitting element according to any one of claims 1 to 12, wherein the light-emitting portion includes a light-emitting layer containing a light-emitting body composed of at least an organic compound.

14. The light-emitting element according to claim 13, wherein the organic compound is an organometallic complex.

15. An image display device comprising the light-emitting element according to any one of claims 1 to 14.

16. A lighting device comprising the light-emitting element according to any one of claims 1 to 14.
